# EUROPEAN PATENT APPLICATION

(11) **EP 4 718 733 A1**
(43) Date of publication of application: **01.04.2026**
(21) Application number: 25198983.6
(22) Date of filing: 29.08.2025
(51) Int. Cl.: H04B 1/18

(54) **ACTIVE PHASE SHIFTER WITH QUADRATURE HYBRID COUPLER**

(30) Priority: 25.09.2024 US 202418896548
(71) Applicant: Apple Inc., Cupertino, CA 95014 (US)
(72) Inventor: ZHAO, Yi, Cupertino, 95014 (US); CHOU, Ethan Lo, Cupertino, 95014 (US)
(74) Representative: Froud, Christopher Andrew

(57) **Abstract**

Wireless communication circuitry (24) may include active phase shifter circuitry. The active phase shifter circuitry (54) may include a quadrature hybrid coupler (56) and amplifiers (52-1, 52-2) coupled to the outputs of the quadrature hybrid coupler (56). An additional quadrature hybrid (64) coupler may be coupled to the amplifiers (52-1, 52-2).

## Description

This application claims priority to U.S. patent application No. 18/896,548, filed September 25, 2024.

### Field

This disclosure relates generally to electronic devices such as electronic devices with wireless communications circuitry.

### Background

Electronic devices are often provided with wireless communications capabilities. An electronic device with wireless communications capabilities has wireless communications circuitry with one or more antennas. Radio-frequency transceiver circuitry in the wireless communications circuitry uses the antennas to transmit and receive radio-frequency signals.

Wireless communications circuitry can include phase shifter circuitry, e.g., for operating a phased antenna array. It can be challenging to design phase shifter circuitry for the wireless communications circuitry.

### Summary

An electronic device may include wireless communications circuitry. The wireless communications circuitry may include phase shifter circuitry such as one or more radio-frequency signal phase shifters (sometimes referred to simply as radio-frequency phase shifters or phase shifters). A phase shifter may be an active phase shifter that includes an input quadrature hybrid coupler and amplifier circuitry communicatively coupled to the input quadrature hybrid coupler. Amplifiers in the amplifier circuitry can exhibit different variable gains across outputs of the input quadrature hybrid coupler to perform phase shifts. The amplifier circuitry and an output quadrature hybrid coupler may be configured to provide termination resistor noise cancellation caused by the termination resistor communicatively coupled to the input quadrature hybrid coupler. If desired, other types of amplifier circuitry such as low noise amplifier circuitry may be communicatively coupled to the outputs of the input quadrature hybrid coupler.

An aspect of the disclosure provides a radio-frequency signal phase shifter. The radio-frequency signal phase shifter can include a first quadrature hybrid coupler having first and second ports, first and second amplifiers communicatively coupled to the first port, third and fourth amplifiers communicatively coupled to the second port, and a second quadrature having a first port communicatively coupled to the first and third amplifiers and having a second port communicatively coupled to the second and fourth amplifiers.

An aspect of the disclosure provides wireless communications circuitry. The wireless communications circuitry can include an active phase shifter that is configured to receive a radio-frequency signal and that includes an output quadrature hybrid coupler. The output quadrature hybrid coupler can be configured to receive a first phase-shifted version of the radio-frequency signal at a first input of the output quadrature hybrid coupler, receive a second phase-shifted version of the radio-frequency signal at a second input of the output quadrature hybrid coupler, and provide, at an output of the output quadrature hybrid coupler, a third phase-shifted version of the radio-frequency signal based on the first and second phase-shifted versions of the radio-frequency signal.

An aspect of the disclosure provides wireless communications circuitry. The wireless communications circuitry can include a phase shifter. The phase shifter can include a quadrature hybrid coupler having an input configured to receive a radio-frequency signal, having a first output, and having a second output, and can include first amplifier circuitry communicatively coupled to the first output and to the second output and configured to provide a phase shift for the radio-frequency signal by exhibiting first and second gains for processing signals received from the first and second outputs of the quadrature hybrid coupler, respectively. The wireless communications circuitry can include second amplifier circuitry communicatively coupled to the first output and to the second output and configured to exhibit a same third gain for processing signals received from the first and second outputs of the quadrature hybrid coupler.

### Brief Description of the Drawings

FIG. 1 is a diagram of an illustrative electronic device having wireless communications circuitry in accordance with some embodiments.
FIG. 2 is a diagram of illustrative wireless communications circuitry having radio-frequency signal phase shifter circuitry in accordance with some embodiments.
FIG. 3 is a diagram of an illustrative active radio-frequency signal phase shifter in accordance with some embodiments.
FIG. 4 is a circuit diagram of an illustrative active radio-frequency signal phase shifter in accordance with some embodiments.
FIG. 5 is a graph of illustrative relationships between signals generated within an active radio-frequency signal phase shifter in accordance with some embodiments.
FIG. 6 is a graph of illustrative scattering parameter metrics when operating an active radio-frequency signal phase shifter in different modes in accordance with some embodiments.
FIG. 7 is a graph of illustrative noise metrics when operating an active radio-frequency signal phase shifter in different modes in accordance with some embodiments.

### Detailed Description

An electronic device may be provided with wireless communications circuitry. The wireless communications circuitry may include radio-frequency signal phase shifter circuitry for changing the phase of radio-frequency signals. In some illustrative configurations sometimes described herein as an example, the radio-frequency signal phase shifter circuitry can include phase shifters each communicatively coupled to a corresponding antenna, the antennas forming a phased antenna array. The phase shifters may allow independent beam angle control for beam forming at the phased antenna array.

Passive phase shifters can introduce radio-frequency signal losses along the radio-frequency signal paths (e.g., the receive chains and/or the transmit chains), which can be undesirable, as this tightens the performance requirements for other radio-frequency components along the signal paths (which may be costly, in terms of power, area, etc., to achieve). To mitigate these issues, the phase shifters may be implemented using active phase shifters. In illustrative configurations sometimes described herein as an example, an active phase shifter may include a quadrature hybrid coupler and amplifier circuitry configured to provide variable gain to in-phase and quadrature signals from the quadrature hybrid coupler to achieve the phase shifting functionality.

A terminal resistor communicatively coupled to the quadrature hybrid coupler can introduce noise into the phase-shifted radio-frequency signal output by the active phase shifter. Accordingly, in illustrative configurations sometimes described herein as an example, the amplifier circuitry of the active phase shifter can be configured to generate first and second phase-shifted versions of the input radio-frequency signal that exhibit a 90 degree phase difference from each other. An additional output quadrature hybrid coupler may receive the first and second phase-shifted versions of the input radio-frequency signal containing the terminal resistor noise and generate a third phase-shifted version of the input radio-frequency signal without the terminal resistor noise.

If desired, additional amplifier circuitry such as low noise amplifier circuitry may be communicatively coupled to the outputs of the quadrature hybrid coupler, which can advantageously achieve wideband input impedance matching when the quadrature hybrid coupler is provided at the inputs of low noise amplifier circuitry.

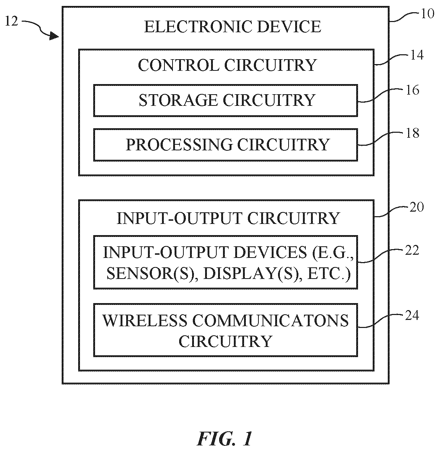

An illustrative electronic device having phase shifter circuitry formed from active phase shifter(s) (e.g., configured in the manners described above) is shown in FIG. 1. FIG. 1 is a diagram of an illustrative electronic device such as electronic device 10. Electronic device 10 may be a computing device such as a laptop computer, a desktop computer, a computer monitor containing an embedded computer, a tablet computer, a cellular telephone, a media player, or other handheld or portable electronic device, a smaller device such as a wristwatch device, a pendant device, a headphone or earpiece device, a device embedded in eyeglasses or other equipment worn on a user's head, or other wearable or miniature device, a television, a computer display that does not contain an embedded computer, a gaming device, a navigation device, an embedded system such as a system in which electronic equipment with a display is mounted in a kiosk or automobile, a wireless internet-connected voice-controlled speaker, a home entertainment device, a remote control device, a gaming controller, a peripheral user input device, a wireless base station or access point, equipment that implements the functionality of two or more of these devices, or other electronic equipment.

As shown in the schematic diagram of FIG. 1, device 10 may include components located on or within an electronic device housing such as housing 12. Housing 12, which may sometimes be referred to as a case, may be formed of plastic, glass, ceramics, fiber composites, metal (e.g., stainless steel, aluminum, metal alloys, etc.), other suitable materials, or a combination of these materials. In some situations, parts or all of housing 12 may be formed from dielectric or other low-conductivity material (e.g., glass, ceramic, plastic, sapphire, etc.). In other situations, housing 12 or at least some of the structures that make up housing 12 may be formed from metal elements.

Device 10 may include control circuitry 14. Control circuitry 14 may include storage such as storage circuitry 16. Storage circuitry 16 may include hard disk drive storage, nonvolatile memory (e.g., flash memory or other electrically-programmable-read-only memory configured to form a solid-state drive), volatile memory (e.g., static or dynamic random-access-memory), etc. Storage circuitry 16 may include storage that is integrated within device 10 and/or removable storage media.

Control circuitry 14 may include processing circuitry such as processing circuitry 18. Processing circuitry 18 may be used to control the operation of device 10. Processing circuitry 18 may include one or more microprocessors, microcontrollers, digital signal processors, host processors, baseband processor integrated circuits, application processors, application specific integrated circuits, central processing units (CPUs), general purpose processors, or other types of processors. Control circuitry 14 may be configured to perform operations in device 10 using hardware (e.g., dedicated hardware or circuitry), firmware, and/or software. Software code for performing operations in device 10 may be stored on storage circuitry 16 (e.g., storage circuitry 16 may include non-transitory (tangible) computer readable storage media that stores the software code). The software code may sometimes be referred to as program instructions, software, data, instructions, or code. Software code stored on storage circuitry 16 may be executed by processing circuitry 18.

Control circuitry 14 may be used to run software on device 10 such as satellite navigation applications, internet browsing applications, voice-over-internet-protocol (VOIP) telephone call applications, email applications, media playback applications, operating system functions, etc. To support interactions with external equipment, control circuitry 14 may be used in implementing communications protocols. Communications protocols that may be implemented using control circuitry 14 include internet protocols, wireless local area network (WLAN) protocols (e.g., IEEE 802.11 protocols - sometimes referred to as Wi-Fi^{®}), protocols for other short-range wireless communications links such as the Bluetooth^{®} protocol or other wireless personal area network (WPAN) protocols, IEEE 802.11ad protocols (e.g., ultra-wideband protocols), cellular telephone protocols (e.g., 3G protocols, 4G (LTE) protocols, 5G New Radio (NR) protocols, etc.), MIMO protocols, antenna diversity protocols, satellite navigation system protocols (e.g., global positioning system (GPS) protocols, global navigation satellite system (GLONASS) protocols, etc.), antenna-based spatial ranging protocols (e.g., radio detection and ranging (RADAR) protocols or other desired range detection protocols for signals conveyed at millimeter and centimeter wave frequencies), or any other desired communications protocols. Each communications protocol may be associated with a corresponding radio access technology (RAT) that specifies the physical connection methodology used in implementing the protocol.

Device 10 may include input-output circuitry 20. Input-output circuitry 20 may include input-output devices 22. Input-output devices 22 may be used to allow data to be supplied to device 10 and to allow data to be provided from device 10 to external devices. Input-output devices 22 may include user interface devices, data port devices, and other input-output components. For example, input-output devices 22 may include touch sensors, displays, light-emitting components such as displays without touch sensor capabilities, buttons (mechanical, capacitive, optical, etc.), scrolling wheels, touch pads, key pads, keyboards, microphones, cameras, buttons, speakers, status indicators, audio jacks and other audio port components, digital data port devices, motion sensors (accelerometers, gyroscopes, and/or compasses that detect motion), capacitance sensors, proximity sensors, magnetic sensors, force sensors (e.g., force sensors coupled to a display to detect pressure applied to the display), etc. In some configurations, keyboards, headphones, displays, pointing devices such as trackpads, mice, electronic pencil (e.g., a stylus), and joysticks, and other input-output devices may be coupled to device 10 using wired or wireless connections (e.g., some of input-output devices 22 may be peripherals that are coupled to a main processing unit or other portion of device 10 via a wired or wireless link).

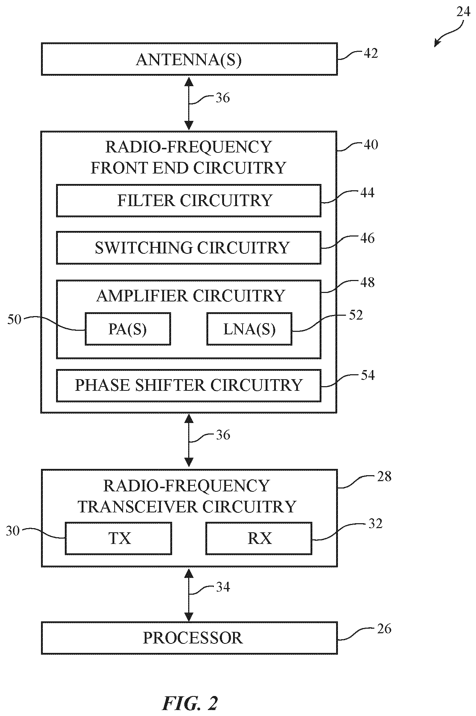

Input-output circuitry 20 may include wireless communications circuitry such as wireless communications circuitry 24 (sometimes referred to herein as wireless circuitry 24) for wirelessly conveying radio-frequency signals. FIG. 2 is a diagram showing illustrative components within wireless circuitry 24. As shown in FIG. 2, wireless circuitry 24 may include one or more processors such as processor(s) 26, radio-frequency (RF) transceiver circuitry such as radio-frequency transceiver circuitry 28, radio-frequency front end circuitry such as radio-frequency front end circuitry 40 (which, when integrated, may sometimes be referred to as front end module 40), and one or more antennas such as antenna(s) 42. Each processor 26 may be a baseband processor, application processor, general purpose processor, microprocessor, microcontroller, digital signal processor, host processor, or other type of processor. If desired, processor(s) 26 may be implemented as part of control circuitry 14. A processor 26 may be coupled to transceiver circuitry 28 over path 34. Transceiver circuitry 28 may be coupled to antenna(s) 42 via radio-frequency transmission line path(s) 36. Radio-frequency front end circuitry 40 may be disposed along (e.g., on) radio-frequency transmission line path(s) 36 between transceiver circuitry 28 and antenna(s) 42.

In the example of FIG. 2, wireless circuitry 24 is illustrated as including a single processor 26, a single instance of transceiver circuitry 28, a single instance of front end circuitry 40, and a single set of antenna(s) 42. In general, wireless circuitry 24 may include any number of processors 26, any number of instances of transceiver circuitry 28, any number of instances of front end circuitry 40, and any number of sets of antenna(s) 42. Each processor 26 may be coupled to one or more transceivers (e.g., instances of transceiver circuitry 28) over respective paths 34. Each transceiver 28 may include a transmitter circuit 30 configured to output uplink signals to antenna(s) 42, may include a receiver circuit 32 configured to receive downlink signals from antenna(s) 42, and may be coupled to one or more antennas 42 over respective radio-frequency transmission line paths 36. Each radio-frequency transmission line path 36 may have respective front end circuitry 40 disposed thereon. If desired, two or more instances of (different types of) front end circuitry 40 may be disposed on the same radio-frequency transmission line path 36. If desired, one or more of the radio-frequency transmission line paths 36 in wireless circuitry 24 may be implemented without any front end circuitry 40 disposed thereon.

Antenna(s) 42 may be formed using any desired antenna structures. For example, antenna(s) 42 may each be an antenna with an antenna resonating element that is formed from loop antenna structures, patch antenna structures, inverted-F antenna structures, slot antenna structures, planar inverted-F antenna structures, helical antenna structures, monopole antennas, dipole antennas, hybrids of these designs, etc. Two or more antennas 42 may be arranged into one or more phased antenna arrays (e.g., for conveying radio-frequency signals at millimeter wave frequencies). Parasitic elements may be included in antenna 42 to adjust antenna performance. Antenna 42 may be provided with a conductive cavity that backs the antenna resonating element of antenna 42 (e.g., antenna 42 may be a cavity-backed antenna such as a cavity-backed slot antenna).

Each radio-frequency transmission line path 36 may be coupled to an antenna feed on antenna 42. The antenna feed may, for example, include a positive antenna feed terminal and a ground antenna feed terminal. Radio-frequency transmission line path 36 may have a positive transmission line signal path that is coupled to the positive antenna feed terminal on antenna 42. Radio-frequency transmission line path 36 may have a ground transmission line signal path that is coupled to the ground antenna feed terminal on antenna 42. This example is merely illustrative and, in general, antennas 42 may be fed using any desired antenna feeding scheme. If desired, antenna 42 may have multiple antenna feeds (e.g., for providing multiple polarizations) that are coupled to one or more radio-frequency transmission line paths 36.

Radio-frequency transmission line path 36 may include transmission lines that are used to route radio-frequency signals within device 10 (FIG. 1). These transmission lines may include coaxial cables, microstrip transmission lines, stripline transmission lines, edge-coupled microstrip transmission lines, edge-coupled stripline transmission lines, transmission lines formed from combinations of transmission lines of these types, etc. If desired, transmission lines in radio-frequency transmission line paths 36 may be integrated into rigid printed circuit boards and/or flexible printed circuit substrates.

In performing wireless signal transmission, processor(s) 26 may provide transmit signals (e.g., digital or baseband signals) to transceiver circuitry 28 over path 34. Transceiver circuitry 28 may further include circuitry for converting the transmit (baseband) signals received from processor 26 into corresponding radio-frequency signals. For example, transceiver circuitry 28 may include mixer circuitry for up-converting (or modulating) the transmit (baseband) signals to radio-frequencies prior to transmission over antenna 42. The example of FIG. 2 in which processor 26 communicates with transceiver circuitry 28 is merely illustrative. In general, transceiver circuitry 28 may communicate with a baseband processor, an application processor, general purpose processor, a microcontroller, a microprocessor, or one or more processors within circuitry 18 (e.g., implementing the functions of processor 26). Transceiver circuitry 28 may also include digital-to-analog converter (DAC) and/or analog-to-digital converter (ADC) circuitry for converting signals between digital and analog domains. Transceiver circuitry 28 may use transmitter (TX) 30 to transmit the radio-frequency signals over antenna(s) 42 via radio-frequency transmission line path 36 and front end circuitry 40. Antenna(s) 42 may transmit the radio-frequency signals to external wireless equipment by radiating the radio-frequency signals into free space.

In performing wireless reception, antenna(s) 42 may receive radio-frequency signals from the external wireless equipment. The received radio-frequency signals may be conveyed to transceiver circuitry 28 via radio-frequency transmission line path 36 and front end circuitry 40. Transceiver circuitry 28 may include circuitry such as receiver (RX) 32 for receiving signals from front end circuitry 40 and for converting the received radio-frequency signals into corresponding baseband signals. For example, transceiver circuitry 28 may include mixer circuitry for down-converting (or demodulating) the received radio-frequency signals to baseband frequencies prior to conveying the received signals to processor 26 (or control circuitry 18 implementing the function of processor 26) over path 34.

Radio-frequency front end circuitry 40 may operate on the radio-frequency signals conveyed (transmitted and/or received) over radio-frequency transmission line path 36. Front end circuitry 40 may, for example, include front end module (FEM) components such as radio-frequency filter circuitry 44 (e.g., low pass filters, high pass filters, notch filters, band pass filters, multiplexing circuitry, duplexer circuitry, diplexer circuitry, triplexer circuitry, etc.), switching circuitry 46 (e.g., one or more radio-frequency switches), radio-frequency amplifier circuitry 48 (e.g., one or more power amplifier circuits 50 and/or one or more low-noise amplifier circuits 52), radio-frequency phase shifter circuitry 54 (e.g., one or more phase shifters that modify the phase of received radio-frequency signals), impedance matching circuitry (e.g., circuitry that helps to match the impedance of antenna 42 to the impedance of radio-frequency transmission line 36), antenna tuning circuitry (e.g., networks of capacitors, resistors, inductors, and/or switches that adjust the frequency response of antenna 42), radio-frequency coupler circuitry, charge pump circuitry, power management circuitry, digital control and interface circuitry, and/or any other desired circuitry that operates on the radio-frequency signals transmitted and/or received by antenna 42. Each of the front end module components may be mounted to a common (shared) substrate such as a rigid printed circuit board substrate or flexible printed circuit substrate. If desired, the various front end module components may also be integrated into a single integrated circuit chip (e.g., a single integrated circuit die) or a single integrated circuit package.

Filter circuitry 44, switching circuitry 46, amplifier circuitry 48, phase shifter circuitry 54 and other circuitry may be disposed along (e.g., on) radio-frequency transmission line path 36, may be incorporated into a front end module, and/or may be incorporated into antenna 42 (e.g., to support antenna tuning, to support operation in desired frequency bands, etc.). At least some of these components may form antenna tuning components that are adjusted (e.g., using control circuitry 14) to adjust the frequency response and wireless performance of antenna 42 over time.

While control circuitry 14 is shown separately from wireless circuitry 24 in the example of FIG. 1 for the sake of clarity, wireless circuitry 24 may include processing circuitry that forms a part of processing circuitry 18 and/or storage circuitry that forms a part of storage circuitry 16 of control circuitry 14 (e.g., portions of control circuitry 14 may be implemented on wireless circuitry 24). As an example, processor 26 and/or portions of transceiver circuitry 28 (e.g., a host processor on transceiver circuitry 28) may form a part of control circuitry 14. Control circuitry 14 (e.g., portions of control circuitry 14 formed on processor 26, portions of control circuitry 14 formed on transceiver circuitry 28, and/or portions of control circuitry 14 that are separate from wireless circuitry 24) may provide control signals (e.g., over one or more control paths in device 10) that control the operation of front end circuitry 40.

Transceiver circuitry 28 may be separate from front end circuitry 40. For example, transceiver circuitry 28 may be formed on another substrate such as the main logic board of device 10, a rigid printed circuit board, or flexible printed circuit different than the one on which front end circuitry 40 is provided.

Radio-frequency transceiver circuitry 28 may handle transmission and/or reception of radio-frequency signals in various radio-frequency communications bands. For example, radio-frequency transceiver circuitry 28 may handle radio-frequency signals in wireless local area network (WLAN) communications bands such as the 2.4 GHz and 5 GHz Wi-Fi^{®} (IEEE 802.11) bands, wireless personal area network (WPAN) communications bands such as the 2.4 GHz Bluetooth^{®} communications band, cellular telephone communications bands such as a cellular low band (LB) (e.g., 600 to 960 MHz), a cellular low-midband (LMB) (e.g., 1400 to 1550 MHz), a cellular midband (MB) (e.g., from 1700 to 2200 MHz), a cellular high band (HB) (e.g., from 2300 to 2700 MHz), a cellular ultra-high band (UHB) (e.g., from 3300 to 5000 MHz), or other cellular communications bands between about 600 MHz and about 5000 MHz (e.g., 3G bands, 4G LTE bands, 5G New Radio Frequency Range 1 (FR1) bands below 10 GHz, 5G New Radio Frequency Range 2 (FR2) bands at millimeter and centimeter wavelengths between 20 and 60 GHz, etc.), a near-field communications (NFC) band (e.g., at 13.56 MHz), satellite navigations bands (e.g., an L1 global positioning system (GPS) band at 1575 MHz, an L5 GPS band at 1176 MHz, a Global Navigation Satellite System (GLONASS) band, a BeiDou Navigation Satellite System (BDS) band, etc.), an ultra-wideband (UWB) communications band supported by the IEEE 802.15.4 protocol and/or other UWB communications protocols (e.g., a first UWB communications band at 6.5 GHz and/or a second UWB communications band at 8.0 GHz), and/or any other desired communications bands. The communications bands handled (e.g., covered) by radio-frequency transceiver circuitry 28 may sometimes be referred to herein as frequency bands or simply as "bands," and may span corresponding ranges of frequencies.

As described above, front end circuitry 40 may include phase shifter circuitry 54 (sometimes referred to as radio-frequency phase shifter circuitry 54 or radio-frequency signal phase shifter circuitry 54). Phase shifter circuitry 54 may include one or more radio-frequency signal phase shifters (sometimes referred to as radio-frequency phase shifters or phase shifters). In some illustrative configurations described herein as an example, a set of antennas 42 may form a phased antenna array and a phase shifter may be provided for or coupled (e.g., communicatively coupled) to each antenna 42 of the phased antenna array along a corresponding radio-frequency signal path 36 for that antenna. Configured in this manner, the phase shifters may help achieve independent beam angle control for antennas 42 of the phased antenna array (e.g., during beam forming operations).

Each radio-frequency signal path 36 may include radio-frequency signal transmission components forming a radio-frequency transmit chain or transmit path and/or may include radio-frequency signal reception components forming a radio-frequency receive chain or receive path. Configurations in which phase shifters are illustrated along with the reception components and are coupled (e.g., communicatively coupled) to respective radio-frequency receive paths are sometimes shown and described herein as examples. If desired, the same phase shifters may be shared by the transmission components and may be coupled (e.g., communicatively coupled) to the radio-frequency transmit paths (e.g., by switching circuitry such as switching circuitry 46 that selectively couples phase shifters to transmit or receive paths). If desired, separate sets of phase shifters in circuitry 54 may be provided for and dedicated to radio-frequency transmit paths and radio-frequency receive paths, respectively.

As one illustrative example, each phase shifter of circuitry 54 may be coupled to a corresponding antenna 42 of a phased antenna array by transmit and receive components along first and second respective parallel paths (e.g., power amplifier circuitry 50 along a first path, low noise amplifier circuitry 52 along a second path, etc.). The phase shifter and the corresponding antenna may be selectively coupled to the first (transmit) path or the second (receive) path by switching circuitry 46. Downstream in the signal reception direction (e.g., for signals received by antennas 42), the phase shifters for the antennas 42 in the phased antenna array may be coupled to radio-frequency combiner circuitry and other components of front end circuitry 40 before reaching receiver 32 of circuitry 28. Upstream in the signal transmission direction (e.g., for signals to be transmitted by antennas 42), the phase shifter for the antennas 42 in the phased antenna array may be coupled to radio-frequency splitter circuitry and other components of front end circuitry 40 before reaching transmitter 30 of circuitry 28.

While phase shifters can be implemented as passive phase shifters, these passive phase shifters can contribute to radio-frequency signal losses along the radio-frequency signal paths 36 on which they are disposed. The presence of these passive phase shifters and their associated losses can negatively impact the ability of the radio-frequency signal paths 36 to meet certain linearity, noise, gain, and/or other requirements. Accordingly, this tightens the performance requirements for other radio-frequency components along the signal paths 36, which may not be achievable or may be costly, in terms of power, area, etc., to achieve.

To mitigate these issues, phase shifter circuitry 54 may include active phase shifters (e.g., phase shifters that include active components such as amplifiers) that not only can eliminate the above-mentioned losses but can also improve radio-frequency signal conveyance characteristics along the radio-frequency signal paths 36 (e.g., by imparting gains to the signals). Accordingly, in illustrative configurations sometimes described herein as an example, an active phase shifter of circuitry 54 may be provided for each antenna 42 of a phased antenna array.

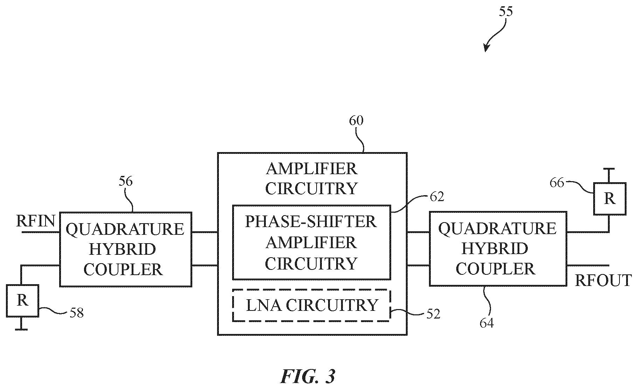

FIG. 3 is a diagram of an illustrative active phase shifter 55. A given phase shifter 55 may be coupled (e.g., communicatively coupled) to a radio-frequency signal path 36 and provided for a given antenna 42 in the phased antenna array. Accordingly, multiple instances of phase shifter 55 may be provided for the phased antenna array and the radio-frequency signal paths 36 coupled thereto.

As shown in FIG. 3, phase shifter 55 may include a quadrature hybrid coupler 56. Quadrature hybrid coupler 56 may have four ports. A first port of quadrature hybrid coupler 56 may be configured to receive an input radio-frequency signal RFIN (e.g., the radio-frequency signal received by phase shifter 55 and is phase-shifted by phase shifter 55) and may sometimes be referred to as an input or input port of quadrature hybrid coupler 56. In some illustrative configurations sometimes described herein as an example, the radio-frequency signal RFIN may be a signal received by an antenna 42 in the phased antenna array, conveyed across a radio-frequency receive path portion, and received at the input port of quadrature hybrid coupler 56.

A second port of quadrature hybrid coupler 56 may be an isolation port, sometimes referred to as an (additional) input or input port. The isolation port of quadrature hybrid coupler 56 may be communicatively coupled to a termination resistor 58 (e.g., having a resistance of 50 Ohms). A first terminal of resistor 58 may be communicatively coupled to quadrature hybrid coupler 56 and a second terminal of resistor 58 may be communicatively coupled to a reference voltage terminal (e.g., a ground voltage terminal).

The third and fourth ports of quadrature hybrid coupler 56 may provide (e.g., generate) output signals based on the input radio-frequency signals RFIN and may sometimes be referred to as first and second outputs, respectively, (or as first and second output ports, respectively). In particular, the first output of quadrature hybrid coupler 56 may provide an in-phase signal based on the input radio-frequency signal. The second output of quadrature hybrid coupler 56 may provide a quadrature signal based on the input radio-frequency signal. Because quadrature hybrid coupler 56 splits the input signal RFIN equally into the in-phase and quadrature signals with equal magnitudes but a 90 degree phase difference between them, the in-phase and quadrature signals may sometimes be referred to as in-phase and quadrature components of the input signal RFIN.

The outputs of quadrature hybrid coupler 56 may be communicatively coupled to radio-frequency amplifier circuitry 60. To achieve phase-shifter functionality, amplifier circuitry 60 may include radio-frequency phase-shifter amplifier circuitry 62 having inputs communicatively coupled to the outputs of quadrature hybrid coupler 56. In particular, phase-shifter amplifier circuitry 62 (e.g., amplifiers or amplifier stages therein) may apply a first gain to the in-phase signal output from quadrature hybrid coupler 56 and may apply a second gain (e.g., different than the first gain) to the quadrature signal output from quadrature hybrid coupler 56. The difference in the gains applied to (and therefore the resulting magnitudes of) the in-phase and quadrature signals will result in a phase shift when the in-phase and quadrature signals are summed to produce a phase-shifted version of the input radio-frequency signal RFIN.

The use of the first and second different gains will produce a particular degree of phase shift. Accordingly, by varying the first and second gains applied by amplifier circuitry 62 to the in-phase and quadrature signals, respectively, different degrees of phase shift can be achieved, thereby providing the phase shift functionality of phase shifter 55. The resulting phase-shifted signal (e.g., the summed in-phase and quadrature signals processed using first and second gains) will also be provided with the corresponding gain applied to the in-phase and quadrature signals.

While the use of quadrature hybrid coupler 56 and amplifier circuitry 62 may be sufficient to form an active phase shifter, the above-mentioned resulting phase-shifted signal may contain a noise component caused by the presence of termination resistor 58 and the unequal magnitudes of the in-phase and quadrature signals to which different gains are applied to provide the phase shift. This noise component may sometimes be referred to as termination resistor noise or a termination resistor noise component.

Accordingly, in illustrative configurations sometimes described herein as an example, phase shifter 55 may include termination resistor noise cancellation circuitry (sometimes referred to generally as noise cancellation circuitry) that removes the termination resistor noise from the final phase-shifted version of the input radio-frequency signal RFIN. In particular, the noise cancellation circuitry may be formed from a portion (e.g., some amplifier(s) or amplifier stage(s)) of phase-shifter amplifier circuitry and an output quadrature hybrid coupler 64 communicatively coupled to phase-shifter amplifier circuitry 62. In configurations in which output quadrature hybrid coupler 64 is provided, quadrature hybrid coupler 56 may sometimes be referred to as input quadrature hybrid coupler 56.

To provide the termination resistor noise cancellation functionality, phase-shifter amplifier circuitry 62 may generate first and second phase-shifted versions of the input radio-frequency signal RFIN that have the same magnitude but are 90 degree phase-shifted with respect to each other (e.g., having a 90 degree phase difference between them).

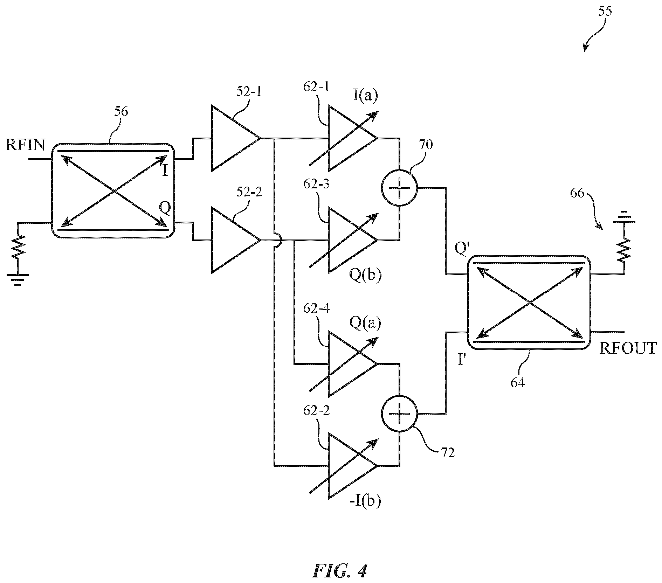

In illustrative configurations sometimes described herein as an example, each phase-shifted version of the input radio-frequency signal RFIN may be generated in an analogous manner as described above, in the scenario without considering termination resistor noise. In particular, the first phase-shifted version of the input signal RFIN may be a sum of an in-phase component and a quadrature component of the input signal RFIN respectively applied (e.g., by amplifier circuitry 62) with two gains different from each other (e.g., first and third gains applied by amplifiers 62-1 and 62-3 in the example of FIG. 4). The second phase-shifted version of the input signal RFIN may be a sum of an in-phase component and a quadrature component of the input signal RFIN respectively applied (e.g., by amplifier circuitry 62) with two gains different from each other (e.g., second and fourth gains applied by amplifiers 62-2 and 62-4 in the example of FIG. 4).

To achieve the same magnitude and the 90 degree phase shift for the first and second phase-shifted versions of the input radio-frequency signal RFIN, the four gains applied by amplifier circuitry 62 may have particular relationships with one another. For example, the third gain may be an inverted (e.g., negative) version of the second gain, and the fourth gain may be the same as the first gain.

As shown in FIG. 3, output quadrature hybrid coupler 64 may have four ports. First and second ports of quadrature hybrid coupler 64 may be coupled (e.g., communicatively coupled) to outputs of amplifier circuitry 62. The first and second ports may respectively receive the first and second phase-shifted versions of the input signal RFIN provided based on the corresponding sums of amplified versions of the in-phase and quadrature signals provided by quadrature hybrid coupler 56. Accordingly, the first and second ports of quadrature hybrid coupler 64 may sometimes be referred to as first and second inputs, respectively, (or as first and second input ports, respectively).

A third port of quadrature hybrid coupler 64 may be an isolation port, sometimes referred to as an output or output port. The isolation port of quadrature hybrid coupler 64 may be coupled to a termination resistor 66 (e.g., having a resistance that is the same as the resistance of termination resistor 58). A first terminal of resistor 66 may be coupled to quadrature hybrid coupler 64 and a second terminal of resistor 66 may be coupled to a reference voltage terminal (e.g., supplying the same reference voltage as the voltage supplied by the reference voltage terminal coupled to resistor 58).

A fourth port of quadrature hybrid coupler 64 may be configured to provide an output radio-frequency signal RFOUT (e.g., the radio-frequency signal output by phase shifter 55 that is a (final) phase-shifted version of the input signal RFIN) and may sometimes be referred to as an (additional) output or output port of quadrature hybrid coupler 64. In some illustrative configurations sometimes described herein as an example, the radio-frequency signal RFOUT may be output by quadrature hybrid coupler 64 to a radio-frequency combiner that also receive other phase-shifted radio-frequency signal(s) from other antenna(s) in the same phased antenna array, and after being combined with the other phase-shifted radio-frequency signal(s) at the combiner, is conveyed downstream to other front end components, a receiver (e.g., receiver 32), etc.

The final (or third) phase-shifted version of the input signal RFIN provided by quadrature hybrid coupler 64 as output signal RFOUT is generated based on the first and second phase-shifted versions of the input radio-frequency signal RFIN received at the first and second inputs of quadrature hybrid coupler 64, respectively. Because the first and second phase-shifted versions of the input radio-frequency signal both contain the termination resistor noise component and have equal magnitudes but a 90 degree phase difference between them, quadrature hybrid coupler 64 may remove the noise component when combining the first and second phase-shifted versions of the input radio-frequency signal to generate output signal RFOUT, thereby producing a (final or third) phase-shifted version of the input radio-frequency signal without noise contribution from the termination resistor of input quadrature hybrid coupler 56.

In some illustrative configurations sometimes described herein as an example, amplifier circuitry 60 coupled (e.g., communicatively coupled) between input quadrature hybrid coupler 56 and output quadrature hybrid coupler 64 may also include additional amplifier circuitry (e.g., in addition to phase-shifter amplifier circuitry 62) such as low-noise amplifier circuitry 52 (e.g., containing amplifier(s) exhibiting a better noise figure than amplifier(s) in amplifier circuitry 62). If desired, the additional amplifier circuitry may include other types of amplifier circuitry, e.g., power amplifier circuitry 50 in configurations in which phase shifter 55 is provided along with transmit chain components.

FIG. 4 is a circuit diagram of an illustrative implementation of an active phase shifter (e.g., active phase shifter 55 in FIG. 3). In the example of FIG. 4 (similar to the example of FIG. 3), input quadrature hybrid coupler 56 may have a first input port configured to receive input radio-frequency signal RFIN, an isolation port coupled to resistor 58, a first output configured to provide an in-phase signal (I) (e.g., a component of signal RFIN), and a second output configured to provide a quadrature signal (Q) (e.g., a component of signal RFIN).

The first output of input quadrature hybrid coupler 56 may be coupled (e.g., communicatively coupled) to an in-phase signal path. A radio-frequency amplifier 52-1 (sometimes referred to as amplifier stage 52-1) may be coupled along (e.g., disposed on) the in-phase signal path and coupled (e.g., communicatively coupled) to the first output of input quadrature hybrid coupler 56 (via the in-phase signal path). Amplifier 52-1 may be configured to process the signal received on the in-phase signal path (e.g., amplify the in-phase signal (I) by exhibiting and applying a first gain). The second output of input quadrature hybrid coupler 56 may be coupled to a quadrature signal path. A radio-frequency amplifier 52-2 (sometimes referred to as amplifier stage 52-2) may be coupled along (e.g., disposed on) the quadrature signal path and coupled (e.g., communicatively coupled) to the second output of input quadrature hybrid coupler 56 (via the quadrature signal path). Amplifier 52-2 may be configured to process the signal received on the quadrature signal path (e.g., amplify the quadrature signal (Q) by exhibiting and applying the same gain as amplifier 52-1).

Amplifiers 52-1 and 52-2 may form a balanced amplifier circuit (e.g., to implement balanced low-noise amplifier circuitry such as amplifier circuitry 52 in FIG. 3). Advantageously, because the inputs of amplifiers 52-1 and 52-2 are coupled (e.g., communicatively coupled) to the respective outputs of quadrature hybrid coupler 56, this configuration provides wideband impedance matching.

In the example of FIG. 4, phase amplifier circuitry 62 (FIG. 3) may include four radio-frequency amplifiers 62-1, 62-2, 62-3, and 62-4 (sometimes referred to as amplifier stages) coupled (e.g., communicatively coupled) between quadrature hybrid couplers 56 and 64, or more specifically between the balanced amplifiers (e.g., amplifiers 52-1 and 52-2) and quadrature hybrid coupler 64. Amplifiers 62-1, 62-2, 62-3, and 62-3 may be coupled along (e.g., disposed on) respective branches coupled to either the in-phase signal path or the quadrature signal path. Because amplifiers 62-1, 62-2, 62-3, and 62-4 can exhibit different gains at the same time to provide a given phase shift and can vary these gains across time for adjustable phase shifts, the four branches may sometimes be referred to as variable gain branches or paths and amplifiers 62-1, 62-2, 62-3, and 62-4 may be referred to as variable gain amplifiers. These characteristics of amplifiers 62-1, 62-2, 62-3, and 62-4 differs from the characteristics of amplifiers 52-1 and 52-2 which exhibit the same gain at the same time to provide a balanced amplifier (but the same gain of amplifiers 52-1 and 52-2 can be varied across time, if desired).

The branches on which amplifiers 62-1 and 62-2 are disposed may be coupled (e.g., communicatively coupled) to the in-phase signal path. Accordingly, amplifiers 62-1 and 62-2 may have inputs that are each coupled (e.g., communicatively coupled) to the output of amplifier 52-1 and each coupled (e.g., communicatively coupled) to the first output of input quadrature hybrid coupler 56 via amplifier 52-1. In such a manner, amplifiers 62-1 and 62-2 may exhibit and respective gains (a) and (-b) and apply them to in-phase signal (I) (e.g., the version of the in-phase signal output by amplifier 52-1). This may result in signal I(a), a gain of (a) being applied to the in-phase signal (I), being provided at an output of amplifier 62-1 and result in signal -I(b), a gain of (-b) being applied to the in-phase signal (I), being provided at an output of amplifier 62-2.

The branches on which amplifiers 62-3 and 62-4 are disposed may be coupled (e.g., communicatively coupled) to the quadrature signal path. Accordingly, amplifiers 62-3 and 62-4 may have inputs that are each coupled (e.g., communicatively coupled) to the output of amplifier 52-2 and each coupled (e.g., communicatively coupled) to the second output of input quadrature hybrid coupler 56 via amplifier 52-2. In such a manner, amplifiers 62-3 and 62-4 may exhibit and respective gains (b) and (a) and apply them to quadrature signal (Q) (e.g., the version of the quadrature signal output by amplifier 52-2). This may result in signal Q(b), a gain of (b) being applied to the quadrature signal (Q), being provided at an output of amplifier 62-3 and result in signal Q(a), a gain of (a) being applied to the quadrature signal (Q), being provided at an output of amplifier 62-4.

A summing circuit 70 (e.g., a current summing circuit) may be coupled (e.g., communicatively coupled) to the outputs of amplifiers 62-1 and 62-3. Summing circuit 70 may receive corresponding output signals I(a) and Q(b) and provide a sum of signals I(a) and Q(b) as the output signal Q' of summing circuit 70. Signal Q' may be a first phase-shifted version of input signal RFIN (e.g., because the summation of the in-phase and quadrature signals amplified with different gains to exhibit different magnitudes provides a phase shift).

A summing circuit 72 (e.g., a current summing circuit) may be coupled (e.g., communicatively coupled) to the outputs of amplifiers 62-2 and 62-4. Summing circuit 72 may receive corresponding output signals -I(b) and Q(a) and provide a sum of signals -I(b) and Q(a) as the output signal I' of summing circuit 72. Signal I' may be a second phase-shifted version of input signal RFIN (e.g., because the summation of the in-phase and quadrature signals amplified with different gains to exhibit different magnitudes provides a phase shift).

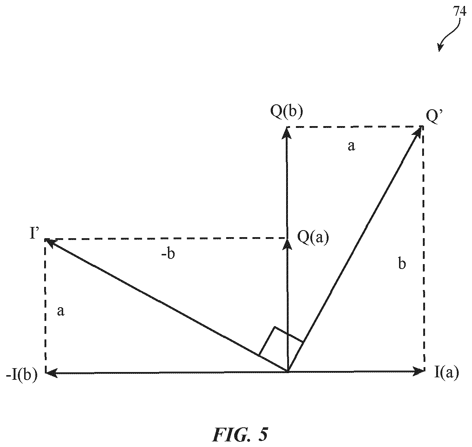

The relationships between the gains exhibited by amplifiers 62-1, 62-2, 62-3, and 62-4 may facilitate the generation of signals Q' and I' that have the same magnitude but with signal Q' exhibiting a 90 degree phase difference with respect to signal I'. FIG. 5 shows a graph 74 illustrating the different amplifier gains and corresponding output signals (at a given time) with respect to the in-phase and quadrature signals.

In particular, the horizontal axis represents the in-phase component (I) and the vertical axis represents the quadrature component. As shown in FIG. 5, signal I(a) generated by amplifier 62-1 has a value of 'a' in the in-phase component and no quadrature component, and signal Q(b) generated by amplifier 62-3 has a value of 'b' in the quadrature component and no in-phase component. When signals I(a) and Q(b) are summed, the resulting signal Q' has a value of 'a' in the in-phase component and a value of 'b' in the quadrature component.

Signal -I(b) generated by amplifier 62-2 has a value of '-b' in the in-phase component and no quadrature component, and signal Q(a) generated by amplifier 62-4 has a value of 'a' in the quadrature component and no in-phase component. When signals -I(b) and Q(a) are summed, the resulting signal I' has a value of '-b' in the in-phase component and a value of 'a' in the quadrature component. Accordingly, signals Q' and I' have the same magnitude but with signal Q' exhibiting a 90 degree phase difference with respect to signal I'.

Referring back to FIG. 4, when signals Q' and I' having characteristics as described above are received by quadrature hybrid coupler 64, quadrature hybrid coupler 64 may remove termination resistor noise (e.g., caused by resistor 58 and the differing gains of a and b being applied to the in-phase and quadrature signals) when providing (e.g., generating) a third phase-shifted version of the input radio-frequency signal RFIN based on signals Q' and I'.

As similarly described in the example of FIG. 3, output quadrature hybrid coupler 64 may have a first input port coupled to the output of summing circuit 70 (e.g., communicatively coupled to amplifiers 62-1 and 62-3) and configured to receive signal Q' (e.g., the first phase-shifted version of the input radio-frequency signal RFIN). Output quadrature hybrid coupler 64 may have a second input port coupled to the output of summing circuit 72 (e.g., communicatively coupled to amplifiers 62-2 and 62-4) and configured to receive signal I' (e.g., the second phase-shifted version of the input radio-frequency signal RFIN). Output quadrature hybrid coupler 64 may have an isolation port coupled (e.g., communicatively coupled) to resistor 66 (e.g., providing the same resistance as resistor 58). Output quadrature hybrid coupler 64 may have an output configured to provide the output radio-frequency signal RFOUT of phase shifter 55. The output radio-frequency signal RFOUT may be a third phase-shifted version of the radio-frequency signal RFIN based on (e.g., combined from) signal Q' (e.g., the first phase-shifted version of the input radio-frequency signal RFIN) and signal I' (e.g., the second phase-shifted version of the input radio-frequency signal RFIN) but the noise component caused by resistor 58 may be absent from the output radio-frequency signal RFOUT.

Control circuitry 14 (FIG. 1) and/or processor(s) 26 may be configured to adjust (e.g., by providing control signals, bias currents and/or voltages, etc., based on gathered (sensor) data or other information on radio-frequency signals, wireless circuitry operations, etc.) amplifier circuitry 60 (FIG. 3), phase-shifter amplifier circuitry 62 (FIG. 3), other amplifier circuitry in amplifier circuitry 60 such as low-noise amplifier circuitry 52 (FIG. 3), switching circuitry such as switching circuitry 46 (FIG. 2), amplifiers 52-1 and 52-2 (FIG. 4), amplifiers 62-1, 62-2, 62-3, and 62-4 (FIG. 4), and/or other radio-frequency components in wireless circuitry 24, e.g., to provide different phase shifts for radio-frequency signals from one or more antennas such as antenna(s) in a phased antenna array.

As a first example, control circuitry 14 and/or processor(s) 26 may adjust amplifiers 62-1, 62-2, 62-3, and 62-4 (FIG. 4) to provide respective gains (e.g., such that gains (a) and (b) in FIG. 4 both exhibit the same unit gain) in a first mode of operation to provide a first degree of phase shift (e.g., to provide a phase shift of 45 degrees or 135 degrees). As a second example, control circuitry 14 and/or processor(s) 26 may adjust amplifiers 62-1, 62-2, 62-3, and 62-4 (FIG. 4) to provide respective gains (e.g., such that only one of gains (a) or (b) in FIG. 4 exhibits the unit gain, while the other one exhibits no gain) in a second mode of operation to provide a second degree of phase shift (e.g., to provide a phase shift of 0 degrees, 90 degrees, or 180 degrees).

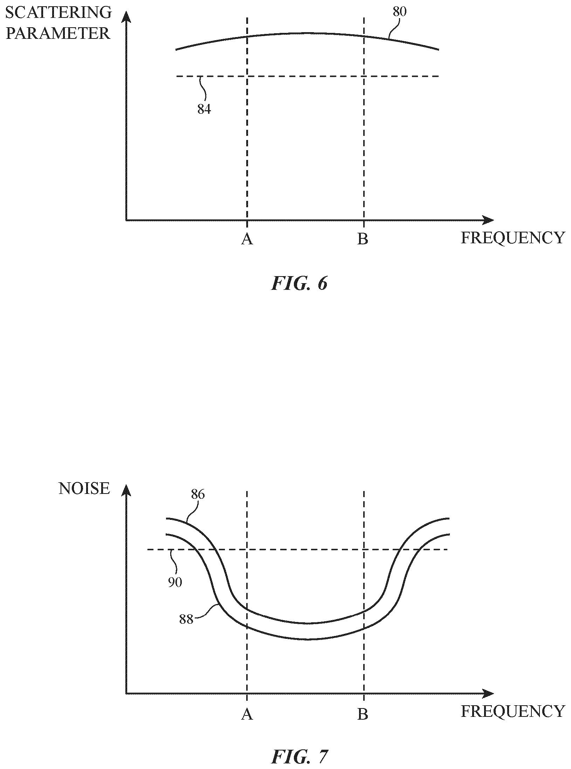

FIG. 6 is a graph illustrating scattering parameter metrics with respect to frequency for operating an active phase shifter (e.g., active phase shifter 55 in FIG. 4) in the above-mentioned first and second modes of operation. In particular, curve 80 shows an illustrative forward-direction scattering parameter (e.g., S₂₁) during operation in the first mode of operation (e.g., to provide a 45- or 135-degree phase shift). Curve 80 can also represent an illustrative forward-direction scattering parameter (e.g., S₂₁) during operation in the second mode of operation (e.g., to provide a 0-, 90-, or 180-degree phase shift). As shown in the example of FIG. 6, illustrative scattering parameter curve 80 (in both modes of operation) can exhibit the same satisfactory power transfer characteristics (e.g., forward voltage gain from input to output of the active phase shifter) by remaining above a desired threshold level indicated by line 84 at least between frequencies A and B (e.g., defining a frequency range therebetween that includes one or more frequencies or frequency bands of interest).

FIG. 7 is a graph illustrating noise metrics with respect to frequency for operating an active phase shifter (e.g., active phase shifter 55 in FIG. 4) in the above-mentioned first and second modes of operation. In particular, curve 86 shows an illustrative noise figure or noise factor metric during operation in the first mode of operation (e.g., to provide a 45- or 135-degree phase shift). Curve 88 shows an illustrative noise figure or noise factor metric during operation in the second mode of operation (e.g., to provide a 0-, 90-, or 180-degree phase shift). As shown in the example of FIG. 7, illustrative noise figure curves 86 and 88 exhibit satisfactory noise figure characteristics by remaining below a desired threshold level indicated by line 80 at least between frequencies A and B (e.g., defining a frequency range therebetween that includes one or more frequencies or frequency bands of interest).

The methods and operations described above in connection with FIGS. 1-7 may be performed by the components of device 10 using software, firmware, and/or hardware (e.g., dedicated circuitry or hardware). Software code for performing these operations may be stored on non-transitory computer readable storage media (e.g., tangible computer-readable storage media) stored on one or more of the components of device 10 (e.g., storage circuitry 16 and/or wireless communications circuitry 24 of FIG. 1). The software code may sometimes be referred to as software, data, instructions, program instructions, or code. The non-transitory computer readable storage media may include drives, non-volatile memory such as non-volatile random-access memory (NVRAM), removable flash drives or other removable media, other types of random-access memory, etc. Software stored on the non-transitory computer readable storage media may be executed by processing circuitry on one or more of the components of device 10 (e.g., processing circuitry in wireless circuitry 24, processing circuitry 18 of FIG. 1, etc.). The processing circuitry may include microprocessors, application processors, digital signal processors, central processing units (CPUs), application-specific integrated circuits with processing circuitry, or other processing circuitry.

In accordance with an aspect of the invention, a radio-frequency signal phase shifter includes a first quadrature hybrid coupler having first and second ports, first and second amplifiers communicatively coupled to the first port, third and fourth amplifiers communicatively coupled to the second port, and a second quadrature hybrid coupler having a first port communicatively coupled to the first and third amplifiers and having a second port coupled to the second and fourth amplifiers.

The first quadrature hybrid coupler optionally has a third port configured to receive a radio-frequency signal and where the first, second, third, and fourth amplifiers are configured to exhibit different gains that collectively provide a phase shift for the radio-frequency signal.

The first output of the first quadrature hybrid coupler optionally provides an in-phase signal and where the second output of the first quadrature hybrid coupler optionally provides a quadrature signal.

The first amplifier is optionally configured to apply a first gain to the in-phase signal, where the second amplifier is configured to apply a second gain to the in-phase signal, where the third amplifier is configured to apply an inverted version of the second gain to the quadrature signal, and where the fourth amplifier is configured to apply the first gain to the quadrature signal.

The first and third amplifiers optionally provide first and second signals, respectively, based on which a first phase-shifted version of the radio-frequency signal is provided to the first port of the second quadrature hybrid coupler and the second and fourth amplifiers optionally provide third and fourth signals, respectively, based on which a second phase-shifted version of the radio-frequency signal is provided to the second port of the second quadrature hybrid coupler.

The first phase-shifted version of the radio-frequency signal optionally has a 90 degree phase difference with respect to the second phase-shifted version of the radio-frequency signal.

The second quadrature hybrid coupler optionally has a third port configured to output a third phase-shifted version of the radio-frequency signal based on the first and second phase-shifted versions of the radio-frequency signal.

The first quadrature hybrid coupler optionally has an isolation port communicatively coupled to an isolation resistor, where the first and second phase-shifted versions of the radio-frequency signal each contain a noise component caused by the isolation resistor, and where the noise component is absent from the third phase-shifted version of the radio-frequency signal.

The radio-frequency signal phase shifter optionally includes fifth and sixth amplifiers communicatively coupled between the first and second quadrature hybrid couplers.

The fifth and sixth amplifiers optionally form low noise amplifier circuitry, where the fifth amplifier is communicatively coupled between the first port of first quadrature hybrid coupler and the first amplifier, and where the sixth amplifier is communicatively coupled between the second port of the first quadrature hybrid coupler and the third amplifier.

In accordance with an aspect of the invention, wireless communications circuitry includes, an active phase shifter that is configured to receive a radio-frequency signal and that includes an output quadrature hybrid coupler configured to receive a first phase-shifted version of the radio-frequency signal at a first input of the output quadrature hybrid coupler, receive a second phase-shifted version of the radio-frequency signal at a second input of the output quadrature hybrid coupler, and provide, at an output of the output quadrature hybrid coupler, a third phase-shifted version of the radio-frequency signal based on the first and second phase-shifted versions of the radio-frequency signal.

The first and second phase-shifted versions of the radio-frequency signal each optionally contain a noise component, and where the output quadrature hybrid coupler is configured to remove the noise component from the third phase-shifted version of the radio-frequency signal when generating the third phase-shifted version of the radio-frequency signal.

The first and second phase-shifted versions of the radio-frequency signal optionally have a same magnitude and are 90 degree phase-shifted versions of each other.

The active phase shifter optionally includes amplifier circuitry communicatively coupled along multiple variable gain paths each of which includes a variable gain amplifier of the amplifier circuitry and first and second combinations of which are used to provide the first and second phase-shifted versions of the radio-frequency signal, respectively.

The active phase shifter optionally includes an input quadrature hybrid coupler having first and second outputs, where each variable gain amplifier of the variable gain amplifiers included in the variable gain paths is communicatively coupled to one of the first or second outputs of the input quadrature hybrid coupler.

The input quadrature hybrid coupler optionally has an input configured to receive the radio-frequency signal from a given antenna in a plurality of antennas forming a phased antenna array.

In accordance with an aspect of the invention, wireless communications circuitry includes, a phase shifter including a quadrature hybrid coupler having an input configured to receive a radio-frequency signal, having a first output, and having a second output, and first amplifier circuitry communicatively coupled to the first output and to the second output and configured to provide a phase shift for the radio-frequency signal by exhibiting first and second gains for processing signals received from the first and second outputs of the quadrature hybrid coupler, respectively, and second amplifier circuitry communicatively coupled to the first output and to the second output and configured to exhibit a same third gain for processing signals received from the first and second outputs of the quadrature hybrid coupler.

The first amplifier circuitry optionally includes first and second amplifiers configured to exhibit the first and second different gains, respectively, where the second amplifier circuitry includes third and fourth amplifiers each configured to exhibit the third gain, where the third amplifier has an input communicatively coupled to the first output of the quadrature hybrid coupler and an output communicatively coupled to an input of the first amplifier, and where the fourth amplifier has an input communicatively coupled to the second output of the quadrature hybrid coupler and an output communicatively coupled to an input of the second amplifier.

The phase shifter optionally includes an additional quadrature hybrid coupler and where the first and second amplifier circuitry are communicatively coupled between the quadrature hybrid coupler and the additional quadrature hybrid coupler.

The second amplifier circuitry optionally forms low noise amplifier circuitry.

The foregoing is merely illustrative and various modifications can be made to the described embodiments. The foregoing embodiments may be implemented individually or in any combination.

It is well understood that the use of personally identifiable information should follow privacy policies and practices that are generally recognized as meeting or exceeding industry or governmental requirements for maintaining the privacy of users. In particular, personally identifiable information data should be managed and handled so as to minimize risks of unintentional or unauthorized access or use, and the nature of authorized use should be clearly indicated to users.

## Claims

1. A radio-frequency signal phase shifter comprising:
a first quadrature hybrid coupler having first and second ports;
first and second amplifiers communicatively coupled to the first port;
third and fourth amplifiers communicatively coupled to the second port; and
a second quadrature hybrid coupler having a first port communicatively coupled to the first and third amplifiers and having a second port coupled to the second and fourth amplifiers.

2. The radio-frequency signal phase shifter of claim 1**,** wherein the first quadrature hybrid coupler has a third port configured to receive a radio-frequency signal and wherein the first, second, third, and fourth amplifiers are configured to exhibit different gains that collectively provide a phase shift for the radio-frequency signal.

3. The radio-frequency signal phase shifter of claim 2, wherein the first output of the first quadrature hybrid coupler provides an in-phase signal and wherein the second output of the first quadrature hybrid coupler provides a quadrature signal.

4. The radio-frequency signal phase shifter of claim 3, wherein the first amplifier is configured to apply a first gain to the in-phase signal, wherein the second amplifier is configured to apply a second gain to the in-phase signal, wherein the third amplifier is configured to apply an inverted version of the second gain to the quadrature signal, and wherein the fourth amplifier is configured to apply the first gain to the quadrature signal.

5. The radio-frequency signal phase shifter of any of claims 2 to 4, wherein the first and third amplifiers provide first and second signals, respectively, based on which a first phase-shifted version of the radio-frequency signal is provided to the first port of the second quadrature hybrid coupler and wherein the second and fourth amplifiers provide third and fourth signals, respectively, based on which a second phase-shifted version of the radio-frequency signal is provided to the second port of the second quadrature hybrid coupler.

6. The radio-frequency signal phase shifter of claim 5, wherein the first phase-shifted version of the radio-frequency signal has a 90 degree phase difference with respect to the second phase-shifted version of the radio-frequency signal.

7. The radio-frequency signal phase shifter of claim 5 or claim 6, wherein the second quadrature hybrid coupler has a third port configured to output a third phase-shifted version of the radio-frequency signal based on the first and second phase-shifted versions of the radio-frequency signal.

8. The radio-frequency signal phase shifter of claim 7, wherein the first quadrature hybrid coupler has an isolation port communicatively coupled to an isolation resistor, wherein the first and second phase-shifted versions of the radio-frequency signal each contain a noise component caused by the isolation resistor, and wherein the noise component is absent from the third phase-shifted version of the radio-frequency signal.

9. The radio-frequency signal phase shifter of any preceding claim, further comprising:
fifth and sixth amplifiers communicatively coupled between the first and second quadrature hybrid couplers.

10. The radio-frequency signal phase shifter of claim 9, wherein the fifth and sixth amplifiers form low noise amplifier circuitry, wherein the fifth amplifier is communicatively coupled between the first port of first quadrature hybrid coupler and the first amplifier, and wherein the sixth amplifier is communicatively coupled between the second port of the first quadrature hybrid coupler and the third amplifier.

11. The radio-frequency signal phase shifter of claim 1, wherein the second quadrature hybrid coupler is configured to receive a first phase-shifted version of a radio-frequency signal at a first input of the output quadrature hybrid coupler, receive a second phase-shifted version of the radio-frequency signal at a second input of the output quadrature hybrid coupler, and provide, at an output of the output quadrature hybrid coupler, a third phase-shifted version of the radio-frequency signal based on the first and second phase-shifted versions of the radio-frequency signal.

12. The radio-frequency signal phase shifter of claim 11, wherein the first and second phase-shifted versions of the radio-frequency signal each contain a noise component, and wherein the output quadrature hybrid coupler is configured to remove the noise component from the third phase-shifted version of the radio-frequency signal when generating the third phase-shifted version of the radio-frequency signal.

13. The radio-frequency signal phase shifter of claim 11 or claim 12, wherein the first and second phase-shifted versions of the radio-frequency signal have a same magnitude and are 90 degree phase-shifted versions of each other.

14. The radio-frequency signal phase shifter of any of claims 11 to 13, wherein the first quadrature hybrid coupler has an input configured to receive the radio-frequency signal from a given antenna in a plurality of antennas forming a phased antenna array.

15. Wireless communication circuitry comprising the radio-frequency signal phase shifter of any of claims 1 to 14.
